**Europäisches Patentamt**

**European Patent Office**

**Office européen des brevets**

(19)

(11) Veröffentlichungsnummer: **0 044 374**
**A1**

(12) ## EUROPÄISCHE PATENTANMELDUNG

(21) Anmeldenummer: **81101730.0**

(22) Anmeldetag: **10.03.81**

(51) Int. Cl.³: **H 03 L 7/14**
**H 04 B 1/68**

(30) Priorität: **22.07.80 DE 3027706**

(43) Veröffentlichungstag der Anmeldung:
**27.01.82 Patentblatt 82/4**

(84) Benannte Vertragsstaaten:
**AT DE FR GB IT NL**

(71) Anmelder: **ROBERT BOSCH GMBH**
**Postfach 50**
**D-7000 Stuttgart 1(DE)**

(72) Erfinder: **Gorzel, Heribert, Dipl.-Ing.**
**Forstweg 33 c**
**D-1000 Berlin 28(DE)**

(72) Erfinder: **Pötter, Manfred, Dipl.-Ing.**
**Weinmeisterhornweg 133**
**D-1000 Berlin 20(DE)**

(74) Vertreter: **Schmidt, Hans-Ekhardt**
**Robert Bosch GmbH Geschäftsbereich Elektronik**
**Patent- und Lizenzabteilung Forckenbeckstrasse 9-13**
**D-1000 Berlin 33(DE)**

(54) **Verfahren zur Frequenzsynchronisation eines freilaufenden, spannungsgesteuerten Oszillators einer Phase-locked-loop(PLL)-Schaltung in einem Funkempfänger.**

(57) Zur Synchronisierung sendet ein Funksender zusätzlich zu den Nutzsignalen vor jeder Nutzsignalübermittlung kurzzeitig ein Synchronsignal in Form eines Bursts aus. Durch den Burst wird eine PLL-Speicherschaltung (20) synchronisiert. Die dabei auftretende Regelspannung ($U_R$) für den Referezoszillator (25) der PLL-Speicherschaltung (20) wird gespeichert, und der gespeicherte Regelspannungswert synchronisiert den Referenzoszillator (25) bis zum Eintreffen des nächsten Bursts.

EP 0 044 374 A1

./...

Fig. 1

0044374

35/80
EK/PLI Scht/Li
18. Juli 1980

ROBERT BOSCH GMBH, 7000 Stuttgart 1

Verfahren zur Frequenzsynchronisation eines freilaufenden, spannungsgesteuerten Oszillators einer
Phase-locked-loop(PLL)-Schaltung in einem Funkempfänger

## Stand der Technik

Die Erfindung geht aus von einem Verfahren nach der Gattung
des Hauptanspruchs.

Zur Wiedergabe eines von einem Funksender ausgestrahlten
Einseitenband-Nutzsignals wird im Empfänger eine Trägerfrequenz hoher Frequenzkonstanz benötigt. Eine befriedigende Übertragungsqualität ist beispielsweise beim Mobilfunk
nur dann gewährleistet, wenn die Trägerfrequenz um höchstens
$\pm$ 20 Hz vom Frequenz-Sollwert abweicht, was im 2-m-Band einer
Frequenzkonstanz von ungefähr $10^{-7}$ entspricht. Diese
Genauigkeit kann bei einer mobilen Funkstation aufgrund des
Energie- und Platzbedarfs mit herkömmlichen Methoden nicht
realisiert werden.

Es ist bekannt (IEE Spectrum, 1978, Heft 7, Single-Sideband
Transmission for Land-Mobile Radio), den in der mobilen Funkstation vorhandenen, die Trägerfrequenz erzeugenden Oszillator durch einen von dem Funksender ausgesendeten Pilotton zu
synchronisieren. Der während der Nutzsignalübertragung übertragene Pilotton kann entweder außerhalb oder innerhalb des
Übertragungsfrequenzbereiches liegen. Bei diesem Verfahren
wirken sich die umfangreichen zusätzlichen Selektionsmittel
sowie die Inkompatibilität beim Datenfunk nachteilig aus.

- 2 -

## Vorteile der Erfindung

Das erfindungsgemäße Verfahren mit den kennzeichnenden Merkmalen des Hauptanspruchs hat den Vorteil, daß durch die Übertragung der Synchronsignale vor der Nutzsignalübermittlung die Übertragung des Nutzsignals in keiner Weise beeinträchtigt wird.

Durch die in den Unteransprüchen aufgeführten Maßnahmen sind vorteilhafte Weiterbildungen und Verbesserungen des im Hauptanspruch angegebenen Verfahrens möglich. Das Verfahren arbeitet besonders vorteilhaft, wenn die Frequenz der Synchronsignale etwa in der Mitte des Nutzsignalfrequenzbereiches liegt. Dann haben nämlich die Synchronsignale den maximalen Abstand zu den Nachbarkanälen, so daß die Nachbarkanalstörungen am geringsten sind.

## Zeichnung

Ein Ausführungsbeispiel der Erfindung ist in der Zeichnung anhand mehrerer Figuren dargestellt und in der nachfolgenden Beschreibung näher erläutert. Die Zeichnung zeigt in

Fig. 1       ein vereinfachtes Blockschaltbild eines
            Funksenders und eines Funkempfängers mit der
            erfindungsgemäßen PLL-Speicherschaltung und

Fig. 2 A - D  den Signalspannungsverlauf in Abhängigkeit
            von der Zeit an den Schaltungspunkten
            A bis D in Fig. 1.

## Beschreibung der Erfindung

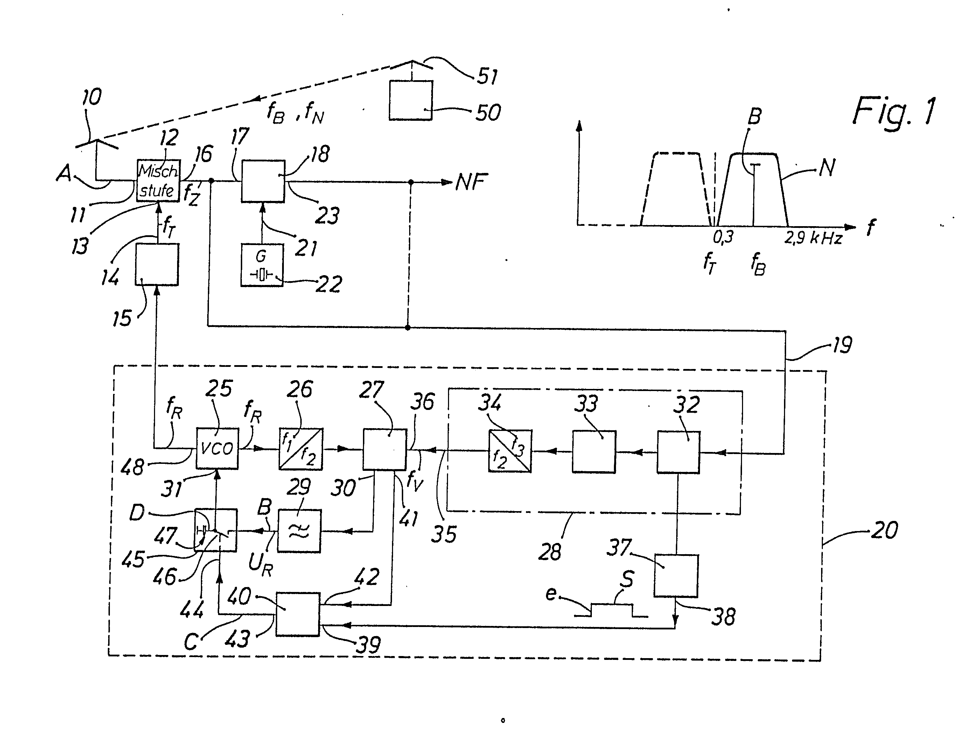

In dem in Fig. 1 gezeigten Blockschaltbild weist ein Einseitenband-Empfänger eine Empfangsantenne 10 auf, die mit einem ersten Eingang 11 einer Mischstufe 12 verbunden ist.

Ein zweiter Eingang 13 der Mischstufe steht mit einem
Ausgang 14 einer Kanal-PLL-Schaltung 15 in Verbindung,
die von einer PLL-Speicherschaltung 20 angesteuert wird.
Von einem Ausgang 16 der Mischstufe 12 führt eine erste
Leitungsverbindung an einen Eingang 17 eines Synchrondemodulators 18 sowie eine zweite Leitungsverbindung an
einen Eingang 19 der PLL-Speicherschaltung 20. Ein
zweiter Eingang 21 des Synchrondemodulators 18 steht mit
einem quarzstabilisierten Oszillator 22 in Verbindung.
Der Synchrondemodulator 18 weist einen NF-Ausgang 23 auf.

Die PLL-Speicherschaltung 20 enthält mehrere aus der PLL-
Technik bekannte Baustufen, nämlich einen freilaufenden,
spannungsgesteuerten Referenzoszillator 25, einen
Frequenzteiler 26, eine Frequenz- und Phasenvergleichsschaltung 27, eine Referenzfrequenzquelle 28 und ein
Tiefpaßfilter 29. Während die Reihenschaltung aus dem
Referenzoszillator 25, dem Frequenzteiler 26 und der
Frequenz- und Phasenvergleichsschaltung 27 einen Vorwärtspfad der PLL-Speicherschaltung bildet, liegt das Tiefpaßfilter 29 in einem Rückwärtspfad zwischen einem ersten
Ausgang 30 der Frequenz- und Phasenvergleichsschaltung 27
und einem Steuereingang 31 des Referenzoszillators 25.
Für die Synchronisierung der PLL-Speicherschaltung 20
durch burstförmige Synchronsignale hat die Referenzfrequenzquelle 28 folgenden Aufbau. Mit dem Eingang 19 der PLL-
Speicherschaltung 20 ist ein Begrenzerverstärker 32 verbunden, der über ein Trackingfilter 33 und einen Frequenzteiler 34 mit einem ersten Ausgang 35 der Referenzfrequenzquelle 28 und einem Referenzfrequenzeingang 36 der Frequenz-
und Phasenvergleichsschaltung 27 in Verbindung steht. Ein
zu dem Begrenzerverstärker 32 gehörender FM-Demodulator 37
steht mit seinem Ausgang 38 mit einem ersten Eingang 39 und
ein zweiter Ausgang 41 der Frequenz- und Phasenvergleichsschaltung 27 mit einem zweiten Eingang 42 einer logischen

Verknüpfungsschaltung 40 in Verbindung, deren Ausgang 43 mit einem ersten Eingang 44 einer elektronischen Schalt- und Speichereinheit 45 verbunden ist. Die Einheit 45 enthält einen der Einfachheit halber durch ein Schaltersymbol gekennzeichneten elektronischen Schalter 46 und einen Speicher 47, das ist im einfachsten Fall ein Kondensator. Der Schalter 46 verbindet in geschlossenem Zustand das Tiefpaßfilter 29 mit dem Eingang 31 des Referenzoszillators 25 und mit dem Speicher 47. Ein Ausgang 48 des Referenzoszillators 25 steht mit einem Eingang der Kanal-PLL-Schaltung 15 in Verbindung. Ein mit 50 bezeichneter Funksender weist eine Sendeantenne 51 auf. Der Funksender 50 steht mit dem Funkempfänger in Funkverbindung.

Die vorstehend beschriebene Schaltung funktioniert folgendermaßen:

Ausgangssituation

Der Schalter 46 der elektronischen Schalt- und Speichereinheit 45 ist geöffnet. Der Speicherkondensator 47 der elektronischen Schalt- und Speichereinheit 45 hat eine beliebige Restspannung $U_C$. Damit gibt der Referenzoszillator 25 eine Referenzfrequenz im Bereich von $f_R \pm \Delta f_R =$ 6,4 MHz $\pm$ 20 Hz ab, wobei $f_R$ die Sollfrequenz und $\Delta f_R$ die maximal zulässige Frequenzabweichung sind. Aufgrund dieser Referenzfrequenz erzeugt die Kanal-PLL-Schaltung 15 eine Frequenz $f_T \pm \Delta f_T =$ 155,85 MHz $\pm$ 500 Hz, wobei $f_T$ die Soll- Trägerfrequenz und $\Delta f_T$ die nach Maßgabe des Verhältnisses $f_T/f_R$ sich ergebende maximale Frequenzablage der Trägerfrequenz ist.

Synchronisation

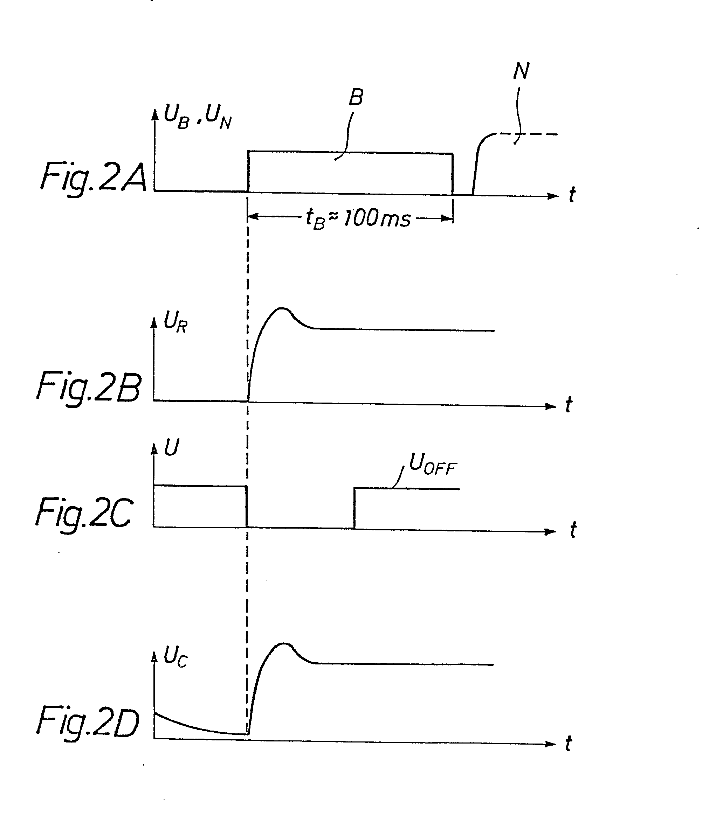

Zunächst sendet der Funksender 50 vor der Nutzsignalübertragung N (vgl. Fig. 2 A) ein Synchronsignal in Form eines Bursts B der Frequenz $f_B$ = 164,85 MHz und der Dauer $t_B \approx$ 50 ms aus. Die Burstfrequenz $f_B$ liegt in der Mitte des Übertragungsbereichs; vgl. Fig. 1 oben.

Im Empfänger wird dieses Signal empfangen und in der Mischstufe 12 mit Hilfe der von der Kanal-PLL-Schaltung 15 gelieferten Trägerfrequenz $f_T \pm \Delta f_T$ = 155,85 MHz $\pm$ 500 Hz in die Zwischenfrequenzlage mit der Frequenz $f_Z$ = 9 MHz $\pm$ 500 Hz umgesetzt. Die Zwischenfrequenz $f_Z$ gelangt über den Begrenzerverstärker 32 zu dem FM-Demodulator 37. Dieser erkennt, ob ein Synchronsignal B empfangen wird. Während der Dauer des Erkennens des Synchronsignals gibt der Frequenzdemodulator eine bestimmte Schaltspannung S an den ersten Eingang 39 der logischen Verknüpfungsschaltung 40 ab. Die Einschaltflanke e der Schaltspannung bewirkt über die logische Verknüpfungsschaltung 40 das Schließen des elektronischen Schalters 46, so daß nun die Regelschleife für das PLL-System aus den Bausteinen 25, 26, 27 und 29 geschlossen ist und der Synchronisiervorgang eingeleitet wird.

Zu diesem Zweck wird zunächst die Zwischenfrequenz $f_Z \pm \Delta f_Z$ = 9 MHz $\pm$ 500 Hz in dem Begrenzerverstärker 32 von Amplitudenstörungen befreit. Das anschließende Trackingfilter 33 sorgt dafür, daß Unterbrechungen im Empfangssignal bzw. in dem davon abgeleiteten Zwischenfrequenzsignal überbrückt werden. In dem Frequenzteiler 34 wird die Zwischenfrequenz so weit heruntergeteilt, daß sie als Vergleichsfrequenz $f_V$ der Frequenz- und Phasenvergleichsschaltung 27 zugeführt werden kann.

Weiterhin wird die Referenzfrequenz $f_R \pm \Delta f_R$ = 6,4 MHz $\pm$ 20 Hz in dem Frequenzteiler 26 heruntergeteilt und ebenfalls der Frequenz- und Phasenvergleichsschaltung 27 zugeführt. Der erste Ausgang 30 der Frequenz- und Phasenvergleichsschaltung 27 liefert eine von der augenblicklichen Frequenz- bzw.

Phasendifferenz abhängige Spannung, die nach Passieren des Tiefpaßfilters 29 etwa den in Fig. 2 B gezeigten zeitlichen Verlauf hat und in bekannter Weise dem Referenzoszillator 25 als Regelspannung $U_R$ zugeführt wird. Der Referenzoszillator 25 wird in der Folge solange nachgeregelt, bis die Frequenz- und Phasenvergleichsschaltung 27 Frequenz- und Phasengleichheit feststellt. Damit ist der Referenzoszillator 25 auf die Sollfrequenz $f_R$ = 6,4 MHz eingerastet. Die Trägerfrequenz $f_T$ beträgt dann 155,85 MHz und die Zwischenfrequenz $f_Z$ des Synchronsignals 9 MHz. ·

Speichervorgang

Nachdem die Synchronisation hergestellt ist, liefert die logische Verknüpfungsschaltung 40 eine bestimmte Steuerspannung zum Öffnen des Schalters 46 der Schalt- und Speichereinheit 45. Damit wird die Regelschleife aufgetrennt.

Der Speicher 47, der sich beim Synchronisiervorgang im Falle eines Kondensators auf eine Spannung $U_C$ = $U_R$ aufgeladen hatte (vgl. Fig. 2 D), ist so beschaffen, daß er seinen Ladezustand für einen längeren Zeitraum aufrechterhält. Dadurch schwingt der Referenzoszillator 25 auch beim Ausbleiben des Synchronsignals B mit der Soll-Referenzfrequenz $f_R$.

Die bestimmte Steuerspannung $U_{OFF}$ (vgl. Fig. 2 C) zum Öffnen des Schalters 46 wird von der logischen Verknüpfungsschaltung 40 nur dann geliefert, wenn zwei Voraussetzungen erfüllt sind, nämlich wenn

1. der FM-Demodulator 37 erkennt, daß ein Synchronsignal B empfangen und die entsprechende Schaltspannung S am Eingang 39 der logischen Verknüpfungsschaltung 40 anliegt, und

2. wenn in der Frequenz- und Phasenvergleichsschaltung 27 Phasengleichheit festgestellt wurde und ein entsprechendes Signal an dem Eingang 42 der logischen Verknüpfungsschaltung 40 anliegt.

35/80                  - 7 -

Die oben erwähnte maximal zulässige Ablage $\pm \Delta f_R = 20$ Hz
des nichtsynchronisierten Referenzoszillators 25 wird dadurch erreicht, daß ein sogenannter TCXO-Oszillator eingesetzt wird.

Die Kanal-PLL-Schaltung 15 enthält stufenweise, dem Kanalraster entsprechend umschaltbare Frequenzteiler, wodurch
die für den jeweiligen Funkkanal erforderliche Trägerfrequenz $f_T$ aus einer Vielzahl von möglichen Trägerfrequenzen
erzeugt werden kann.

Es hat sich gezeigt, daß bei Anwendung des erfindungsgemäßen Verfahrens die Oszillatorfrequenz $f_O$ nach der
Speicherung über einen Zeitraum von etwa zehn Minuten
einen Gesamtfehler von wenigen Hertz aufweist.

Bei der vorstehenden Beschreibung eines Ausführungsbeispiels
wurde von einem AM-Einseitenbandverfahren mit stark unterdrücktem Träger $f_T$ ausgegangen. Das beschriebene Verfahren
läßt sich in analoger Weise jedoch auch bei PM/FM-Systemen
zur Synchronisation abgesetzter Funkrelais mit Vorteil anwenden.

Eine Alternative zu der in Fig. 1 gezeigten Schaltung besteht
darin, daß anstelle der Zwischenfrequenz $f_Z$ die Ausgangsspannung des Synchrondemodulators 18 dem Eingang 19 der
PLL-Speicherschaltung 20 zugeführt wird. Dann wäre das
Teilerverhältnis der Frequenzteiler 26, 34 entsprechend anzupassen.

Nach einer vorteilhaften Weiterbildung des vorstehend
beschriebenen Verfahrens wird das Synchronsignal B als
Bestandteil eines Rufsignals oder eines Quittungssignals vor
jedem Aufbau einer Funkverbindung ausgesendet. Auf diese
Weise ist die Synchronsignalaussendung in das Ruf- oder
Quittungsverfahren integriert.

Bei einem Verfahren, bei dem die Nutzsignale N Sprachsignale sind, kann die Synchronisierung häufiger wiederholt werden, wenn die Synchronsignale während der Sprachsignalübermittlung, vorzugsweise in den Sprachpausen,ausgesendet werden. Zu diesem Zweck sollen die Synchronsignale B für eine derart kurze Dauer ausgesendet werden, daß die Sprachverständlichkeit darunter nicht leidet.

Die in Fig. 1 mit 45 bezeichnete Schalt- und Speichereinheit ist vorzugsweise eine Sample-and-Hold-Schaltung, in der der Regelspannungswert $U_R$ analog gespeichert wird. Es kann jedoch auch von Vorteil sein, den bei synchronisierter PLL-Speicherschaltung 20 auftretenden Regelspannungswert $U_R$ mittels eines Analog/Digital-Wandlers in einen entsprechenden Digitalwert umzuwandeln und diesen Digitalwert dann in einem Digitalspeicher zu speichern. Zum Nachsteuern des Referenzoszillators 25 wird dann der digital gespeicherte Regelspannungswert mittels eines Digital/Analog-Wandlers in eine analoge Regelspannung umgewandelt.

35/80
EK/PLI Scht/Li
18. Juli 1980

ROBERT BOSCH GMBH, 7000 Stuttgart 1

Ansprüche

1. Verfahren zur Frequenzsynchronisation eines freilaufenden, spannungsgesteuerten Oszillators einer Phase-locked-loop-(PLL)-Schaltung in einem Funkempfänger mittels von einem Funksender zusätzlich zu den Nutzsignalen ausgestrahlter Synchronsignale, dadurch gekennzeichnet, daß vor jeder Nutzsignalübermittlung kurzzeitig ein aus einem Burst (B) bestehendes Synchronsignal ausgestrahlt wird, daß der sich bei der Synchronisierung durch den Burst ergebende Wert der Regelspannung ($U_R$) für den Referenzoszillator (25) der PLL-Speicherschaltung (20) in einem Speicher (47) gespeichert wird und daß der gespeicherte Regelspannungswert den Referenzoszillator bis zum Eintreffen des nächsten Bursts synchronisiert.

2. Verfahren nach Anspruch 1, dadurch gekennzeichnet, daß die Frequenz ($f_B$) des Synchronsignals innerhalb des Nutzsignalfrequenzbereiches liegt.

3. Verfahren nach Anspruch 1, dadurch gekennzeichnet, daß die Frequenz ($f_B$) des Synchronsignals etwa in der Mitte des Nutzsignalfrequenzbereiches liegt.

4. Verfahren nach Anspruch 1, dadurch gekennzeichnet, daß der freilaufende, spannungsgesteuerte Referenzoszillator (25) einer PLL-Speicherschaltung (20) nur dann mit der abgespeicherten Regelspannung ($U_R$) beaufschlagt wird, wenn erstens Frequenz- und Phasengleichheit zwischen einer von der Frequenz ($f_R$) des Referenzoszillators (25) und einer von der Frequenz des Synchronsignals abgeleiteten Vergleichsfrequenz ($f_V$) besteht und wenn zweitens der Einschwingvorgang ungestört ist.

- 2 -

5. Verfahren nach einem der Ansprüche 1 bis 4, dadurch
   gekennzeichnet, daß bei einem Funkempfang von SSB-
   Nutzsignalen (N) mit stark unterdrücktem Träger ($f_T$)
   die Oszillatorfrequenz des Referenzoszillators (25)
   als Referenzfrequenz ($f_R$) für eine Kanal-PLL-Schaltung
   (15) dient, deren Oszillatorfrequenz ($f_T$) einer Mischstufe (12) zugeführt wird, die aus der Frequenz ($f_B$)
   der Synchronsignale (B) und der Oszillatorfrequenz ($f_T$)
   eine Zwischenfrequenz ($f_Z$) bzw. nach Demodulation mit
   einem Synchrondemodulator (18) eine Niederfrequenz (NF)
   bildet, die dem Eingang (19) der PLL-Speicherschaltung
   (20) zugeführt wird.

6. Verfahren nach Anspruch 1 bis Anspruch 5, dadurch
   gekennzeichnet, daß das Synchronsignal (B) vor jedem
   Verbindungsaufbau einer Funkverbindung als Bestandteil
   eines Rufsignals oder eines Quittungssignals ausgesendet
   wird.

7. Verfahren nach Anspruch 1, dadurch gekennzeichnet, daß
   in dem Fall, daß die Nutzsignale (N) Sprachsignale sind,
   die Dauer ($t_B$) der Synchronsignale (B) derart kurz
   bemessen ist, daß sie auch während der Nutzsignalübermittlung ausgesendet werden können, ohne die Sprachverständlichkeit in nennenswertem Umfang zu verschlechtern.

8. Verfahren nach Anspruch 1 oder 4, dadurch gekennzeichnet,
   daß der bei synchronisierter PLL-Speicherschaltung (20)
   auftretende Regelspannungswert ($U_R$) analog mittels einer
   Sample-and-Hold-Schaltung gespeichert wird.

9. Verfahren nach Anspruch 1 oder 4, dadurch gekennnzeichnet,
   daß der bei synchronisierter PLL-Speicherschaltung (20)
   auftretende Regelspannungswert ($U_R$) mittels eines Analog/
   Digital-Wandlers in einen entsprechenden Digitalwert

35/80                      - 3 -

umgewandelt, der Digitalwert in einem Digitalspeicher
gespeichert und zum Nachsteuern des Referenzoszillators (25) mittels eines Digital/Analog-Wandlers in
eine analoge Regelspannung umgewandelt wird.

10. Schaltungsanordnung zur Ausübung des Verfahrens nach
    Anspruch 5, dadurch gekennzeichnet, daß der Ausgang (16)
    der Mischstufe (12) mit einer Referenzfrequenzquelle
    (28) der PLL-Speicherschaltung (20) verbunden ist, die
    aus einer Reihenschaltung eines Amplitudenstörungen
    des Synchronsignals (B) beseitigenden Begrenzerverstärkers (32), eines den Einfluß von Phasensprüngen
    reduzierenden Trackingfilters (33) und eines Frequenzteilers (34) besteht, dessen Ausgang mit einem Eingang (36) für die Vergleichsfrequenz (f$_V$) einer
    Frequenz- und Phasenvergleichsschaltung (27) der PLL-
    Speicherschaltung verbunden ist.

11. Schaltungsanordnung nach Anspruch 8, dadurch gekennzeichnet, daß ein eine Regelspannung abgebender Ausgang (30) der Frequenz- und Phasenvergleichsschaltung
    (27) über ein Tiefpaßfilter (29) mit einem Schalter
    (46) verbunden ist, der in geschlossenem Zustand den
    Ausgang des Tiefpaßfilters mit einem Speicher (47) und
    einem Steuereingang (31) des Referenzoszillators (25)
    der PLL-Speicherschaltung (20) verbindet.

12. Schaltungsanordnung nach Anspruch 8 oder 9, dadurch
    gekennzeichnet, daß ein zweiter, nur bei erkannter
    Frequenz- und Phasengleichheit ein bestimmtes Signal
    abgebender Ausgang (41) der Frequenz- und Phasenvergleichsschaltung (27) mit einem Eingang (42) einer
    logischen Verknüpfungsschaltung (40) und ein zu dem
    Begrenzerverstärker (32) gehörender FM-Demodulator (37)
    mit einem weiteren Eingang (39) der logischen Verknüpfungsschaltung verbunden sind, deren Ausgang (43) mit
    einem Steuereingang (44) des Schalters (46) verbunden
    ist.

Fig. 1

Fig.2A

$U_B, U_N$

B

N

$t_B \approx 100 ms$

Fig.2B

$U_R$

Fig.2C

$U$

$U_{OFF}$

Fig.2D

$U_C$

0044374

Nummer der Anmeldung

EP 81 10 1730

Europäisches
Patentamt

**EUROPÄISCHER RECHERCHENBERICHT**

| | **EINSCHLÄGIGE DOKUMENTE** | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | DE - A - 2 729 499 (ALPS ELECTRIC) <br> * Seite 3, Zeile 1 - Seite 6, Zeile 20; Seite 8, Zeile 16 - Seite 13, Zeile 13; Figuren 3-6 * <br><br> -- <br><br> DE - A - 2 720 432 (NIPPON TELE-VISION) <br> * Seite 7, Zeile 4 - Seite 13, Zeile 35; Figuren 3,6 * <br><br> -- <br><br> US - A - 4 101 844 (MALONE) <br> * Spalte 1, Zeile 29 - Spalte 2, Zeile 68; Figur 1 * <br><br> -- <br><br> DE - A - 1 909 730 (C.I.T.) <br> * Seite 6, Zeile 12 - Seite 8, Zeile 23; Figur 3 * <br><br> -- <br><br> IBM TECHNICAL DISCLOSURE BULLETIN, Band 6, Nr. 12, Mai 1964, Seiten 38,39 <br> New York, U.S.A. <br> E. HOPNER et al.: "Digital gain and frequency control" <br><br> * Insgesamt * <br><br> ---- | 1-3,5, 6,11 <br><br><br><br><br><br> 1,5,9, 11 <br><br><br><br><br> 1,4,8, 11 <br><br><br><br><br> 1,5,8, 10,11 <br><br><br><br><br> 1,4,6, 9 | H 03 L 7/14 <br> H 04 B 1/68 <br><br><br><br><br><br><br> **RECHERCHIERTE SACHGEBIETE (Int. Cl.³)** <br><br> H 03 L 7/14 <br> H 04 B 1/68 <br> H 03 D 1/24 <br> H 04 L 27/06 <br> H 04 B 1/30 <br><br><br><br> **KATEGORIE DER GENANNTEN DOKUMENTE** <br><br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patent-familie, übereinstimmendes Dokument |

| Der vorliegende Recherchenbericht wurde für alle Patentansprüche erstellt. | | |
|---|---|---|
| Recherchenort <br> Den Haag | Abschlußdatum der Recherche <br> 29-10-1981 | Prüfer <br> DHONDT |

EPA form 1503.1 06.78